Europäisches Patentamt

European Patent Office

Office européen des brevets

(11) Publication number: **0 487 902 A2**

# EUROPEAN PATENT APPLICATION

(21) Application number: **91118200.4**

(22) Date of filing: **25.10.91**

(51) Int. Cl.5: **H03L 7/081**

(30) Priority: **29.11.90 US 620224**

(43) Date of publication of application:
**03.06.92 Bulletin 92/23**

(84) Designated Contracting States:
**DE FR GB**

(71) Applicant: **International Business Machines
Corporation
Old Orchard Road
Armonk, N.Y. 10504(US)**

(72) Inventor: **Ewen, John Farley
3441 Deerhaunt Street
Yorktown Heights, N.Y. 10598(US)**

Inventor: **Ferraiolo, Frank David
225 Spruce Street
New Windsor, N.Y. 12553(US)**
Inventor: **Gersbach, John Edwin
500 South Willard Street
Burlington, VT. 05401(US)**
Inventor: **Novof, Ilya Iosephovich
10 Spruce Street
Burlington, VT. 05401(US)**

(74) Representative: **Herzog, Friedrich Joachim,
Dipl.-Ing.
IBM Deutschland GmbH, Patentwesen und
Urheberrecht, Schönaicher Strasse 220
W-7030 Böblingen(DE)**

(54) Delay line calibration circuits.

(57) Calibration loops for a delay line (12'), for example, for digital phase locked logic circuitry for use in ascertaining the phase offset between a data signal and a local clock (10) and to produce a series of phase shifted clocks (f(i)'), are described. The calibration loops include a phase detector (14) coupled to receive as a first input the local clock applied to the delay line and as a second input the delay clock (f(n)') produced by the nth delay element ($D_v$) of an n element delay line. At least one of the delay elements ($D_v$) of the delay line is a variable delay element. The detector outputs a phase difference signal derived from the clocks applied at the first and second inputs. Control circuitry receives the phase difference signal from the detector and produces therefrom a corresponding control signal (CONTROL) which is applied to the at least one variable delay element to vary the delay through the delay line. Specific control circuitry embodiments are provided in the disclosure.

fig. 2

This invention relates in general to communication systems and information and data processing systems, and more particularly, for example, to a digital phase locked logic circuit utilizing a delay line to ascertain the phase offset between a data signal and a local clock and to produce a series of phase shifted clocks.

Various digital phase locked logic (DPLL) circuits are described in the open literature. An early survey is given in an article by W.C. Lindsey et al., entitled "Survey of Digital Phase Locked Loops", Proceedings of the IEEE, Vol. 69, No. 4, April 1981, pp. 410-431. DPLL circuits typically use a local fixed frequency oscillator clock to provide input to a fixed delay line. The fixed delay line is used to determine the phase offset between a data transition and a local DPLL clock, and as a source of phase shifted clocks. Typically upon a data transition occurrence, logic circuits time sort the transition in reference to the local clock and generate an appropriate phase selection signal which selects one of the delay line clocks as an output retiming clock.

For example, a fixed delay line for a DPLL circuit is described by E.A. Zurfluh in U.S. Patent No. 4,677,648, entitled "Digital Phase Locked Loop Synchronizer," assigned to the same assignee as the present invention. According to the patent, a local oscillator clock signal of a given frequency is furnished to an analog delay chain which is used in a dual function, i.e., for determining the phase offset between the data signal and a locally generated clock signal, and for obtaining a phase shifted signal. Evaluation means, upon occurrence of a data signal transition, obtains bi-level tap signal values as a phase offset indication and generates an appropriate phase selection signal which selects one of the delay line tap signals as the output clock. The described evaluation means instantaneously corrects the output clock signal on every data edge transition.

Another example of a fixed delay line for a DPLL circuit is provided by Novof et al. in co-pending U.S. application entitled "Digital Integrating Clock Extractor," Serial No. 07/594,242, assigned to the same assignee as the present invention. A local fixed frequency oscillator clock provides an input signal to a fixed delay line which produces a family of delay clock signals. A retiming clock signal is selected from the family of delay clock signals based upon the integration and periodic analysis of a plurality of time sorted data edge transitions of the received serial data stream. Again, the delay line clock signals are used to time sort data transitions and as a source from which to select the retimed clock signal.

An example of a non-DPLL use for a delay line is set forth by I.I. Novof in a co-pending U.S.

application entitled, "Digital Frequency Multiplication and Data Serialization Circuits," Serial No. 07/588,254, again assigned to the same assignee as the present invention. In this case, a delay line is used to produce a family of Q delay clocks which are used for converting a stream of Q parallel data bits into serial data for transmission and/or processing. The Q synchronous clocks are used by logic circuitry to gate a respective one of the Q parallel data bits such that the Q parallel data bits are sequentially output therefrom as a serial data stream.

Manufacturing, environmental, and power supply variations, etc., can produce significant uncertainty as to the actual clock delay in a fixed delay line. In order to meet desired specifications, a large number of delay elements in a fixed delay line are typically required. Since every delay line tap requires circuitry for data transition, sorting and data processing, the DPLL complexity, chip area, power dissipation, etc., increase proportionately. Unnecessary delay elements also serve to limit DPLL performance.

It is, therefore, an object of the present invention to provide an improved delay line calibration circuit to reduce DPLL circuit complexity and improve performance through a continual delay line calibration technique.

Briefly described, delay line calibration circuits (for example, for a DPLL) are provided by the present invention. The delay line has n serially connected delay elements, with at least one delay element comprising a variable delay element which produces a delay clock as a function of a control signal applied to the element. A local clock drives the delay line. In a basic embodiment, the calibration loop circuitry of the present invention includes a phase detector which is coupled to receive at a first input the local clock applied to the delay line and at a second input the delay clock produced by the nth delay element of the delay line. The phase detector outputs a phase difference signal derived from the difference in phases between the clocks applied to the first and second inputs. Control circuitry is associated with a phase detector for receiving the phase difference signal and producing therefrom a control signal. Application means then applies the control signal to the at least one variable delay element having a variable delay therethrough. The applied control signal varies the delay through the at least one variable delay element such that the phase difference between the local clock and the delay clock of the nth delay element moves towards a desired phase offset.

In a more specific embodiment, each of the delay line delay elements comprise a variable delay element and the application means applies the control signal produced by the control circuitry to each delay line delay element. Further, in one embodiment, the phase difference signal comprises one of an up signal and a down signal. An up signal directs the control circuitry to increase the delay through the delay line and a down signal directs the control circuitry to decrease the delay through the line.

Two embodiments of the control circuitry are depicted and described in detail herein. In one embodiment, the control circuitry includes a digital up/down counter coupled to receive the phase difference signal output from the phase detector and a digital to analog converter coupled to the counter to convert the digital up/down counter value to a corresponding analog control signal which is then applied to each of the variable delay elements. In an alternate embodiment, the control circuitry includes a charge pump and a filter connected to the output thereof, where the value of the filter comprises the control signal. The charge pump is coupled to receive the phase difference signal output from the phase detector and respond thereto by charging or discharging the filter to produce a corresponding analog control signal which is then applied to each of the delay elements of the delay line.

In general the present invention provides for the continuous calibration of a delay line having one or more variable delay elements therein. In a preferred implementation, the delay line has a plurality of variable delay elements which are each fed with a control signal produced by the calibration loop. In a typical configuration, the control signal is defined by the loop so as to minimize the phase difference between the local clock applied to the delay line and the delay clock produced by the nth delay line delay element. The continuous type calibration circuitry of the present invention reduces the circuit complexity otherwise required to realize a given DPLL, while simultaneously improving DPLL performance, and resolution between successive delay clocks of the delay line.

These and other objects, advantages and features of the present invention will be more readily understood from the following detailed description of certain preferred embodiments of the present invention, when considered in conjunction with the accompanying drawings in which:

Figure 1    is a block diagram representation of a fixed delay line and a clock therefor;

Figure 2    is a block diagram representation of a first embodiment of a variable delay line and a calibration circuit pursuant to the present invention; and

Figure 3    is a block diagram representation of a second embodiment of a variable delay line and a calibration circuit pursuant to the present invention.

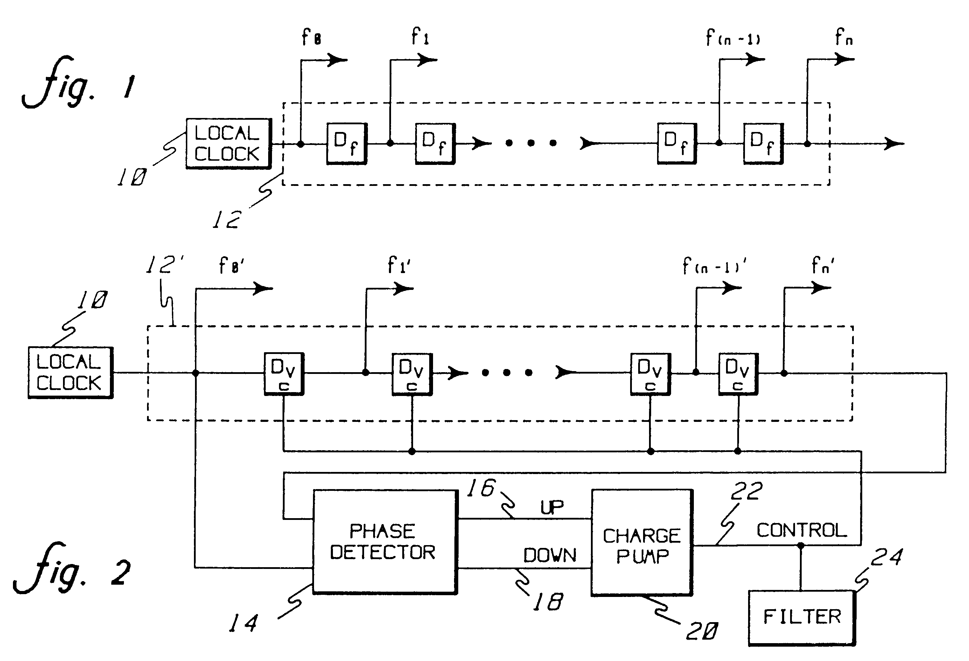

Figure 1 depicts a typical fixed delay line, generally denoted 12, for generating a series of phase shifted clocks such as for use in a digital phase locked loop (DPLL). Delay line 12, which is driven by a local clock 10, includes n fixed delay circuits or delay elements "$D_f$" (n being at least one, but typically greater than one). Line 12 generates through elements "$D_f$" a family of delay clocks f(0), f(1),... f(n-1), f(n), each of different phase. The delay clocks, which are each output at one of n respective taps in line 12, are of the same frequency as local clock 10 but different phase, i.e., except for f(0). In a typical DPLL implementation, the total delay "T" through delay line 12, including the nth delay element "$D_f$", equals the local clock period (or a multiple thereof). The phase delay produced by each delay element "$D_f$" is ideally equal to that produced by each of the other delay elements such that the phase delay "D" between adjacent delay line taps is defined as:

$$D = T/n$$

Wherein:
n = number of fixed delay elements "$D_f$".
As noted above, delay clocks f(0), f(1),... f(n-1), f(n) are used in the typical DPLL implementation to: (1) sort data edge transitions; and (2) as a pool from which to select a retimed DPLL clock based upon the sorted data edge transitions. Significant uncertainty, however, as to actual clock delays in a fixed delay line typically results from manufacturing, environmental, and power supply variations, etc.

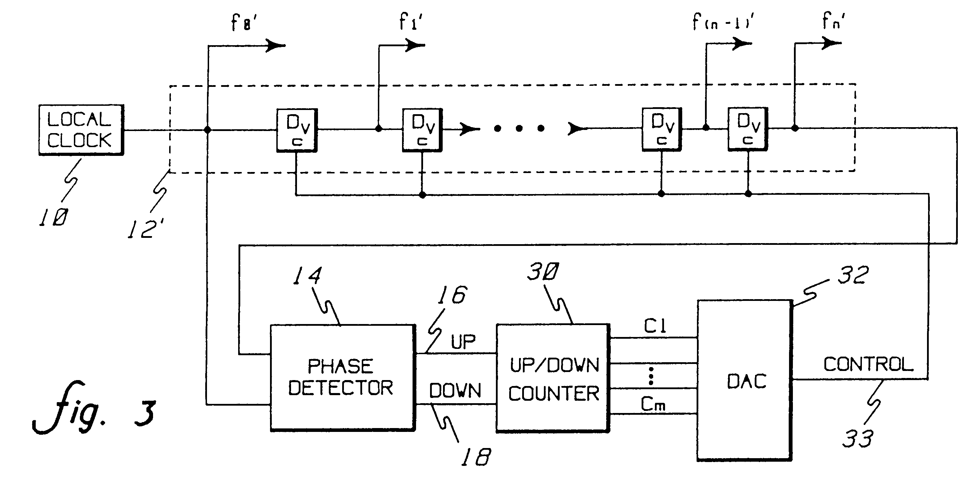

The approach of the present invention, is to substitute variable delay elements for the prior fixed delay elements and provide for continuous calibration of the line. Variable delay elements "$D_v$", which are available in the art, receive an analog voltage/current control signal at a control input "c" (see Figures 2 and 3). This voltage/current signal at input "c" controls the delay through the variable delay elements "$D_v$". Variable delay elements have been designed for a multitude of manufacturing and environmental variations in clock delay. These elements comprise digital circuitry from input to output, but are typically controlled by an analog control signal. Presently available digitally controlled variable delay elements normally perform inferior to analog controlled delay elements.

One embodiment of the calibration loop of the present invention is depicted in Figure 2. The calibration circuit includes a phase detector 14, charge pump 20 and an associated filter 24. The charge value across filter 24, which, e.g., consists of a capacitor or combination of capacitors, comprises the control signal to be applied to the delay elements at each input "c". A local clock 10 is applied to a first input of phase detector 14 in addition to the input of a variable delay line 12', which includes n variable delay elements "$D_v$". Line 12' generates a family of delay clocks, f(0)', f(l)'..., f(n-l)', f(n)', each of difference phase.

Detector 14 receives at a second input the delay clock f(n)' output from the nth variable delay element of line 12'. The phases of local clock f(0)' and delay clock f(n)' are compared at detector 14 and a signal representative of the difference therebetween is output to charge pump 20. If the phase of delay clock f(n)' is behind the local clock f(0)' phase, detector 14 produces an "up" signal on line 16, which directs the charge pump to add charge to filter 24 and thereby increase the control signal, e.g., voltage/current, applied via line 22 to the control input "c" of delay elements "$D_v$" of line 12'. By increasing the control voltage/current through the variable delay elements, the delay through line 12' is increased until clock f(0)' and clock f(n)' become in phase (e.g., clock f(n)' is offset from clock f(0)' by exactly one local clock period).

Should the delay clock f(n)' phase of the nth variable delay element be greater than the local clock f(0)' phase, detector 14 produces a "down" signal on line 18, which directs the charge pump to subtract charge from filter 24 and thereby decrease the control voltage/current applied to the variable delay elements. By decreasing the control voltage applied to elements "$D_v$", the delay through line 12' is reduced until clock f(0)' and clock f(n)' become in phase.

Pursuant to this calibration technique, the delay line clock f(n)' can be locked at a delay of one clock period from local clock f(0)' which is useful for the described DPLL functions. Depending upon the implementation, however, delay line clock f(n)', can be locked to any desired multiple of a clock period or, if the local clock is a symmetrical signal, delay clock f(n)' can be calibrated to one half the clock period rather than a multiple of one local clock period.

Should only digital circuitry be available as is the case with digital CMOS or GaAs technologies, the delay line calibration loop of the present invention can be realized with a circuit embodiment such as that depicted in Figure 3. As shown, a local clock 10 is again fed to the input of a variable delay line 12', along with a first input of a phase detector 14. Detector 14 receives at a second input the delay clock f(n)' of the nth variable delay element "$D_v$". Either an "up" signal or a "down" signal is output by detector 14 on lines 16 & 18, respectively, depending upon the phase difference between local clock f(0)' and delay clock f(n)' from the nth delay element "$D_v$" of line 12'. The phase difference signal output from detector 14 is fed to an up/down counter 30 which in turn feeds a digital to analog converter (DAC) 32. Converter 32 outputs a control signal on line 33 to each of the control inputs "c" of elements "$D_v$" comprising variable delay line 12'.

If the delay clock f(n)' phase is lagging the local clock f(0)' phase, detector 14 produces an "up" signal on line 16 which in turn increments up/down counter 30. The value of counter 30 is available on lines C1... Cm and DAC 32 decodes the new up/down counter 30 output as a higher control voltage/current for application to the variable delay elements "$D_v$". As before, the control voltage/current applied to the variable delay elements will increase the delay through line 12' until, preferably, the local clock f(0)' and delay clock f(n)' phases become equal.

Should the delay clock f(n)' phase precede the local clock f(0)' phase, detector 14 produces a "down" signal on line 18 which decrements up/down counter 30. DAC 32 decodes the new up/down counter output as a lower control voltage/current, which decreases the delay through the variable delay elements "$D_v$" of line 12' until, again preferably, clocks f(0)' and f(n)' become in phase. As with a prior embodiment, the delay line calibration circuit ideally functions in a DPLL environment to lock the delay of clock f(n)' to one local clock period from clock f(0)'.

It will be observed from the above that a continuously calibrated delay line having one or more variable delay elements is provided by the present invention. The variable delay elements receive from the calibration loop a control signal defined in one preferred embodiment so as to minimize the phase difference between the local clock applied to the delay line and the delay clock produced by the last or nth delay line delay element. This approach reduces circuit complexity otherwise required to realize a given DPLL, while simultaneously improving DPLL performance, and resolution between successive delay clocks of the delay line. Further, the delay through the calibrated delay line of the present invention is independent of process parameters, temperature, power supply variations, etc.

Although specific embodiments of the present invention have been illustrated in the accompanying drawings and described in the foregoing detailed description, it will be understood that the invention is not limited to the particular embodiments described herein but rather is capable of numerous rearrangements, modifications and substitutions without departing from the scope of the invention. For example, a delay line may be constructed wherein at least one but less than all of the delay elements comprise variable delay elements, with the remaining elements being fixed delay elements. Such a circuit could be used where the phase resolution between delay clocks output by individual delay elements is less critical. The following claims are intended to encompass all such modifications.

## Claims

1. A calibration circuit for a delay line (12') having an input coupled to receive a clock (10), said delay line having n serially connected delay elements ($D_v$), each of said n delay elements outputting a delay clock (f(i)') of different phase, at least one of said n delay elements comprising a variable delay element which produces a delay clock (f(i)') as a function of a control signal (CONTROL) applied to the element ($D_v$), said calibration circuit comprising:

   a phase detector (14) coupled to receive as inputs the clock (10) applied to the delay line and the delay clock (f(i)') output from the nth serially connected delay element ($D_v$) of the delay line (12'), said phase detector outputting a phase difference signal representative of the difference in phase between said clock inputs;

   control circuitry (16, 18, 20, 22, 24; 30, 32, 33) associated with the phase detector (14) for receiving said phase difference signal (CONTROL) and producing therefrom a control signal;

   means (C, 22; 33) for applying said control signal to said at least one of said n delay elements having a variable delay therethrough; and

   said control signal produced by said control circuitry varying the delay through said at least one of said n delay elements having a variable delay therethrough such that the delay clock output (f(n)') from the nth delay element ($D_v$) approaches a desired phase offset from the applied clock (10).

2. The calibration circuit according to claim 1, wherein each of said n delay elements comprises a variable delay element and wherein said application means includes means for applying said control signal to each of said delay line delay elements.

3. The calibration circuit according to claim 1 or 2, wherein said phase difference signal comprises one of an up signal and a down signal, said up signal directing said control circuitry to produce a control signal (CONTROL) which increases the delay through the delay line (12'), said down signal directing the control circuitry (16, 18, 20, 24; 30, 32, 33) to produce a control signal (CONTROL) which decreases the delay through the delay line (12').

4. The calibration circuit according to any one of the preceding claims, wherein said variable delay elements each require an analog control signal and wherein said control circuitry includes a digital up/down counter (30) coupled to receive the phase difference signal output from said phase detector and a digital to analog converter (32) coupled to the output of said counter, said counter being incremented with receipt of an up signal and decremented with receipt of a down signal, said digital to analog converter converting the digital up/down counter values to a corresponding analog control signal (CONTROL).

5. The calibration circuit according to any one of claims 1 to 4, wherein said delay line delay elements each require an analog control signal (CONTROL) and wherein said control circuitry includes a charge pump (20) and a filter (24) connected to the output thereof, the charge of said filter comprising said analog control signal, said charge pump being coupled to receive said phase difference signal and respond thereto by correspondingly charging/discharging the filter (24) to produce a control signal (CONTROL) that varies the delay through said at least one of said n delay elements having a variable delay therethrough such that the delay clock output (f(n)') from the nth delay element ($D_v$) approaches the desired phase offset from the applied clock (10).

6. The calibration circuit according to any one of claims 2 or - if applicable - 3 or 4, wherein said delay line delay elements each require an analog control signal (CONTROL) and wherein said control circuitry includes a charge pump (20) and a filter (24) connected to the output thereof, said filter's value comprising said analog control signal, said charge pump being coupled to receive said phase difference signal and respond thereto by correspondingly charging/discharging the filter (24) to produce a control signal that (CONTROL) varies the delay through said n delay elements such that the delay clock output (f(n)') from the nth delay element ($D_v$) approaches said preselected phase difference from the applied clock (10).

7. The calibration circuit according to any one of the preceding claims, wherein the control signal output by the control circuitry (16, 18, 20, 22, 24; 30, 32, 33) comprises one of a voltage signal and a current signal.

8. A calibrated delay line coupled to receive a clock (10) and output based thereon a plurality of delay clocks (f(i)') of different phase, said calibrated delay line comprising:

   a delay line (12') having n serially connected variable delay elements ($D_v$), said n delay elements each producing a delay clock (f(i)') of different phase, each of said delay clocks being a function of a control signal (CONTROL) applied to the corresponding delay element ($D_v$); and

   a calibration circuit according to any one of the preceding claims.

9. The calibrated delay line according to claim 8, wherein the phase delay between the delay clocks (f(i)') output by each of said n delay elements are substantially equal.

10. The calibrated delay line according to claim 8 or 9, wherein said desired phase offset is such that said applied clock and said delay clock output by said nth delay element are in phase, whereby said control signal produced by said control circuitry varies the delay through said delay line towards minimizing the phase difference between the applied clock (10) and the delay clock output (f(n)') from the nth serially connected delay element ($D_v$).

fig. 1

fig. 2

EP 0 487 902 A2

EP 0 487 902 A2

$f_0'$  $f_1'$  $f_{(n-1)'}$  $f_n'$

LOCAL CLOCK

10

12'

$D_V$ c  $D_V$ c  • • • •  $D_V$ c  $D_V$ c

14  16  30  32

PHASE DETECTOR  UP  UP/DOWN COUNTER  C1  DAC  CONTROL

DOWN  Cm

18  33

fig. 3